# EUROPÄISCHE PATENTANMELDUNG

(11) **EP 1 028 462 A1**
(43) Veröffentlichungstag der Anmeldung: **16.08.2000**
(21) Anmeldenummer: 00106889.9
(22) Anmeldetag: 18.11.1993
(51) Int. Cl.: H01L 23/495, H01L 23/498

(54) **Elektronikmodul in Flachbauweise**

(30) Priorität: 27.11.1992 CH 363392
(62) Teilanmeldung aus: 93118564.9
(71) Anmelder: Sempac SA, 6330 Cham (CH)
(72) Erfinder: Nicklaus, Karl, 6330 Cham (CH)
(74) Vertreter: Falk, Urs, Dr.

(57) **Zusammenfassung**

Trotz extremer Flachbauweise soll die Bruchneigung des im Kunststoffgehäuse (10) des Elektronikmoduls (M) eingebetteten Halbleiter-Chips (1) wesentlich vermindert werden. Der Chip ist auf der Chip-Insel (22) eines Systemträgers (20) in Form einer Blechstruktur (lead frame) montiert. Die Aussenkontakte (21), die vom Chip teilweise überdeckt werden können, liegen in einer Ebene an der einen Flachseite des Modulgehäuses (10). Der Halbleiter-Chip (1) ist mittels einer isolierenden Klebefolie (2, 2') auf der Chip-Insel (22) montiert.

## Beschreibung

Die Erfindung betrifft ein Elektronikmodul in Flachbauweise, mit Aussenkontakten, die in einer Ebene an der einen Flachseite eines Kunststoffgehäuses liegen und aus einem Systemträger in Form einer flachen Blechstruktur gebildet sind, und ferner mit einem Halbleiter-Chip, der auf der einen Seite des Systemträgers über einer Chip-Insel montiert, von der Kunststoffmasse des Gehäuses umpresst und mit den Aussenkontakten elektrisch verbunden ist.

Ein Elektronikmodul dieser Art ist beispielsweise aus der US 5,134,773 bekannt geworden. Mit jenem Patent wurde ein Verfahren aufgezeigt, welches die Herstellung sogenannter Chipkarten durch direktes Eingiessen des Moduls in das die Karte bildende Kunststoffmaterial ermöglicht, wobei die Aussenkontakte an der einen Flachseite der Karte freiliegen. Das betreffende Elektronikmodul bietet vor allem dadurch besondere Vorteile, dass dessen Aussenkontakte und Chip-Insel aus einem Systemträger in Form einer (normalerweise gestanzten) Blechstruktur (lead frame) bestehen; dies erlaubt eine rationelle, kostengünstige Produktion der Module nach bekannten Verfahren und mit Montageautomaten, wie sie bei der Halbleitermontage für integrierte Schaltungen allgemein üblich sind.

Elektronikmodule in extremer Flachbauweise bieten allerdings besondere Probleme hinsichtlich Festigkeit und Funktionstüchtigkeit im Gebrauch: Anders als bei den verbreiteten Bauformen, bei denen Systemträger und Halbleiter-Chip beidseitig mit Kunststoff umpresst, d.h. in einem Gehäuse ausreichender Dicke eingebettet sind (z.B. sogenannte DIP-Gehäuse für Montage auf Leiterplatten), steht hier nur eins sehr begrenzte Bauhöhe bzw. Gesamtdicke des Moduls zur Verfügung. Beispielsweise haben Chipkarten eine Dicke von lediglich etwa 0,8 mm, und ähnliche Begrenzungen der Modul-Dicke bestehen bei anderen Anwendungen von Flachgehäuse-Modulen, z.B. bei "elektronischen Schlüsseln" o. dgl. Erschwerend kommt hinzu, dass das Elektronikmodul in solchen Gegenständen sehr dauerhaft mechanisch verankert sein muss und ausserdem im Gebrauch erheblichen mechanischen, insbesondere Biege- und Druckbelastungen wie auch u.U. brüsken Temperaturschwankungen ausgesetzt ist. Solche Belastungen wirken entweder direkt von aussen auf das Modul, oder sie werden vom Gegenstand über die erwähnte Verankerung in das Modul eingeleitet.

Extrem flache Modul-Bauformen dieser Art verursachen einerseits gewisse Schwierigkeiten bei der Herstellung durch Spritzgiessen wegen geringen Schichtdicken des Kunststoffs, vor allem aber ist der eingebettete Halbleiter-Chip bruchgefährdet, und zwar bereits bei der Produktion der Module (Ausformen, Test, Handling usw.) wie auch natürlich während dem späteren Gebrauch.

Bei der eingangs genannten Modul-Bauweise ist der Systemträger nur einseitig mit dem Gehäuse in Gestalt einer dünnen Kunststoff-"Scheibe" verbunden. Die Blechteile des Systemträgers selbst ragen dann erheblich zur Festigkeit des Moduls bei, wobei natürlich eine innige Verbindung zwischen den Blechteilen und der Kunststoffmasse besonders wichtig ist. Indessen Ist die Blechstruktur aber durch die schlitzförmigen Ausstanzungen, die die Chip-Insel begrenzen und die Aussenkontakte voneinander trennen, in sich geschwächt. Nach dem Stand der Technik (z.B. US 5,134,773) ist vor allem aus diesem Grund die Flächenausdehnung des Chips Im Hinblick auf die Bruchgefahr auf die Flächenausdehnung der Chip-Insel beschränkt worden.

Mit der vorliegenden Erfindung wird eine weitere Ausgestaltung von Elektronikmodulen der eingangs genannten Art vorgeschlagen, um den besonderen Anforderungen extremer Flachbauweise gerecht zu werden, wobei die technischen und wirtschaftlichen Vorteile der Chip-Montage auf Systemträger (lead frame) beibehalten oder noch vermehrt genutzt werden sollen. Vor allem werden eine insgesamt robustem Bauweise - Widerstandsfähigkeit gegen Biege- und Druckbeanspruchung, optimale Ausnutzung der verfügbaren Gesamtdicke - angestrebt

Diese Aufgabe wird gemäss den kennzeichnenden Merkmalen des Patentanspruches 1 dadurch gelöst, dass der Halbleiter-Chip mittels einer isolierenden Klebefolie auf der Chip-Insel montiert ist.

Zweckmässige weitere Ausgestaltungen des erfindungsgemässen Elektronikmoduls sind in den Ansprüchen 2 bis 4 angegeben.

Nachstehend werden Ausführungsbeispiele des Erfindungsgegenstandes in Verbindung mit der Zeichnung näher erläutert.
- Fig. 1: zeigt die Ausführung eines Systemträgers gemäss einem ersten Ausführungsbeispiel,
- Fig. 2 und 3: zeigen, als Teildarstellung und ausgehend vom Systemträger nach Fig. 1, aufeinanderfolgende Hersteliungsstufen eines beispielsweisen Elektronikmoduls,
- Fig. 4: veranschaulicht schematisch eine Spritzgiessform, in welcher ein Zwischenprodukt nach Fig. 2 zur Herstellung des Kunststoffgehäuses eingelegt ist (Schnitt entlang der Linie IV - IV in Fig. 2),
- Fig. 5: zeigt das fertige, vom Systemträger freigeschnittene und weiter verformte Modul im Schnitt entlang der Linie V - V in Fig. 3,
- Fig. 6: ist eine perspektivische Ansicht des Elektronikmoduls gemäss dem ersten Ausführungsbeispiel,
- Fig. 7: zeigt in etwas grösserem Massstab und im Schnitt ein in einer weiteren Spritzgiessform eingelegtes und positioniertes Modul, in welcher Form das Modul zur Herstellung einer Chipkarte umgossen wird,
- Fig. 8: zeigt, analog zur Fig. 1, eine Variante des Systemträgers gemäss einem zweiten Ausführungsbeispiel,
- Fig. 9 und 10: stellen die den Fig. 2 und 3 entsprechenden weiteren Herstellungsschritte bei der zweiten Ausführungsvariante dar,
- Fig. 11: ist eine Draufsicht auf das fertiggestellte Modul gemäss der zweiten Variante,
- Fig. 12: ist ein Schnitt (in grösserem Massstab) entlang der Linie C - C in Fig 11, und
- Fig. 13: zeigt entsprechend den Schnitt entlang der Linie D - D in Fig. 11.

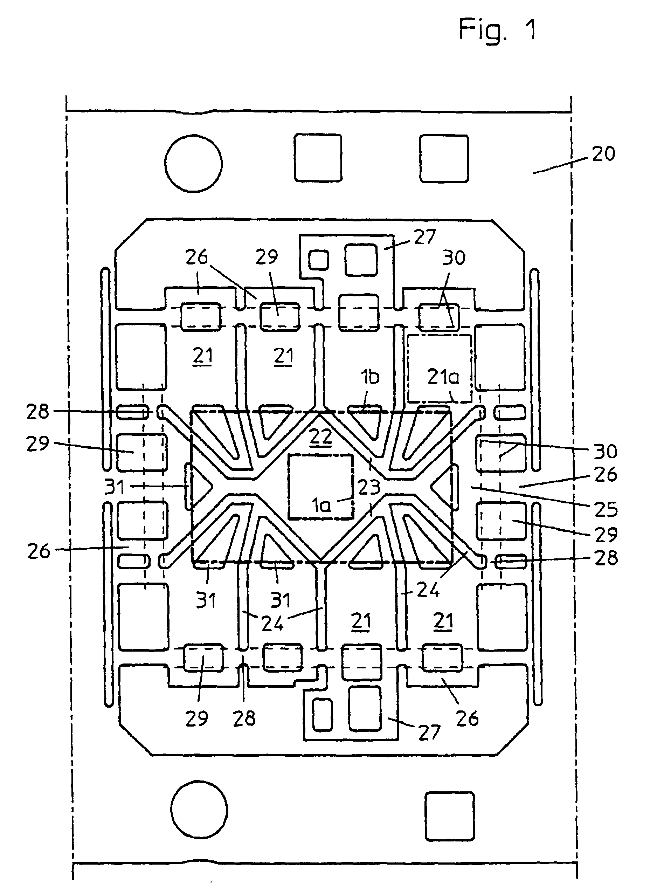

Es werden im folgenden zuerst die Einzelheiten des Systemträgers 20 anhand der Fig. 1 beschrieben, und anschliessend die Herstellung und der Aufbau des gesamten Elektronikmoduls. Fig. 1 zeigt stark vergrössert einen Abschnitt eines Systemträgers 20 in Form einer flachen, normalerweise gestanzten Blechstruktur (lead frame); wie mit strichpunktierten Linien angedeutet, schliessen seitlich weitere, gleichartige Abschnitte an, d.h. es wird in bekannter Weise ein längerer, gestanzter Blechstreifen mit eine Mehrzahl von Abschnitten nach Fig. 1 verwendet. Im Zentrum des Systemträgers 20 befindet sich eine geradlinig begrenzte, viereckige, vorzugsweise quadratische ChipInsel 22. Diese ist durch Schlitze 23 begrenzt und beidseitig an Brücken 25 gehalten. Von den Schlitzen 23 gehen mehrere Schlitze 24 aus, die zusammenmit weiteren Ausstanzungen etwa rechteckige Bereiche 21 bilden. Diese Bereiche steilen am fertigen Elektronikmodul die Aussenkontakte dar. Beim vorliegenden Beispiel handelt es sich um ein Modul für Chipkarten, weshalb entsprechend der hierfür eingeführten Norm acht Aussenkontakte 21 - je vier in zwei parallelen Reihen - vorgesehen sind; zur Verdeutlichung ist in Fig. 1 am einen Aussenkontakt das eigentliche Kontaktfeld 21a strichpunktiert umrandet.

Beim vorliegenden Beispiel weisen die Kontakte 21 wie auch die Brücken 25 in Bereichen, die in der Umgebung der Chip-Insel 22 liegen, Durchbrechungen 31 auf. Weiter ausserhalb sind in jedem Aussenkontakt 21 und in den beiden Brücken 25 fensterartige Durchbrechungen 29 vorgesehen. Etwa in Linie mit diesen Durchbrechungen sind die Kontakte 21 und die Brücken 25 untereinander durch Stege 28 verbunden, an denen die Schlitze 24 enden. An den Brücken 25 und den Kontakten 21 sind sodann über die Stege 28 hinausreichende Fortsätze 26, 27 angeformt. In der Fig. 1 sind schliesslich paarweise parallele, unterbrochene Linien 30 eingezeichnet, die im Bereich der Stege 28 und der "Fenster" 29 liegen und ein Rechteck umschreiben; hierbei handelt es sich um Biegelinien, entlang denen die Fortsätze 26 und 27 später abgekröpft werden. - Die Bedeutung der in diesem Abschnitt erwähnten Einzelheiten des Systemträgers 20 wird Weiter unten im Zusammenhang mit der Herstellung des Moduls und dessen Einbau näher erläutert.

Die Chip-Insel 22 dient der Aufnahme eines Halbleiter-Chips, dessen integrierte Schaltung in bekannter Weise mit den Aussenkontakten 21 elektrisch verbunden wird. In Fig. 1 sind zwei mögliche Lagen und Abmessungen solcher Chips strichpunktiert eingezeichnet: Mit 1a ist ein quadratischer Chip angedeutet, welcher vollständig auf der Chip-Insel 22 Platz findet. Es können jedoch wesentlich grössere Chips montiert werden, die beträchtlich über die Insel 22 hinausreichen und benachbarte Teile der Aussenkontakte 21 überdecken; es ist ein rechteckiges Format 1b eingetragen, welches etwa den beim vorliegenden Beispiel maximal möglichen Chip-Abmessungen entspricht

Von wesentlicher Bedeutung ist nun, dass die Schlitze 23, welche die Chip-Insel 22 begrenzen und diese von den Aussenkontakten 21 trennen, zu den Kanten des quadratischen oder rechteckigen Chips 1 schiefwinklig verlaufen, vorzugsweise, wie dargestellt, unter einem Winkel von etwa 45°. Zusätzlich von Vorteil ist es, wenn wenigstens ein Teil der die Aussenkontakte trennenden, von den Schlitzen 23 ausgehenden Schlitze 24 entlang geknickter Linien verlaufen, wodurch diese Schlitze wenigstens zum Teil (hauptsächlich innerhalb des Chip-Formates 1b) ebenfalls zu den Chip-Kanten schiefwinklig stehen. In der Blechstruktur des Systemträgers 20 bilden die erwähnten Schlitze 23, 24 unvermeidliche Schwächungslinien. Anderseits ist es so, dass in der Struktur des (Silicium-)Einkristallmaterials. aus dem die Chips hergestellt sind, Brüche infolge Biegebeanspruchung praktisch immer parallel zu den Chip-Kanten auftreten. Durch die vorgenannten Massnahmen bzw. die Orientierung des Chip-Formates auf der Chip-Insel wird reicht, dass die Schwächungslinien der tragenden Blechstruktur nicht parallel zu den wahrscheinlichen Bruchlinien im Chip verlaufen, wodurch das Bruchrisiko für den Chip im mechanischen Verband des Moduls erheblich vermindert ist.

Beim vorliegenden Beispiel ist die Anordnung so getroffen, dass die Diagonalen der quadratischen Chip-Insel 22 zu den beiden Reihen der Aussenkontakte 21 parallel bzw. senkrecht stehen; die Chip-Insel könnte - bei gleicher Richtung der Diagonalen etwa auch rhombusförmig gestaltet sein. Jedoch ist grundsätzlich (beispielsweise bei einer anderen Anordnung der Aussenkontakte) auch eine "umgekehrte" Anordnung denkbar, indem, bezogen auf die Hauptachsen des Systemträgers 20, eine quadratische oder rechteckige Chip-Insel "achsparallel", der Chip dagegen "schiefwinklig" angeordnet ist. Auch der Verlauf der die Kontakte trennenden Schlitze 24 kann variiert werden, wobei die angestrebte Wirkung in grösserem oder geringerem Ausmass durch die zum Chip schiefstehenden Abschnitte dieser Schlitze, vor allem in den vom Chip überdeckten Bereichen, erzielt wird.

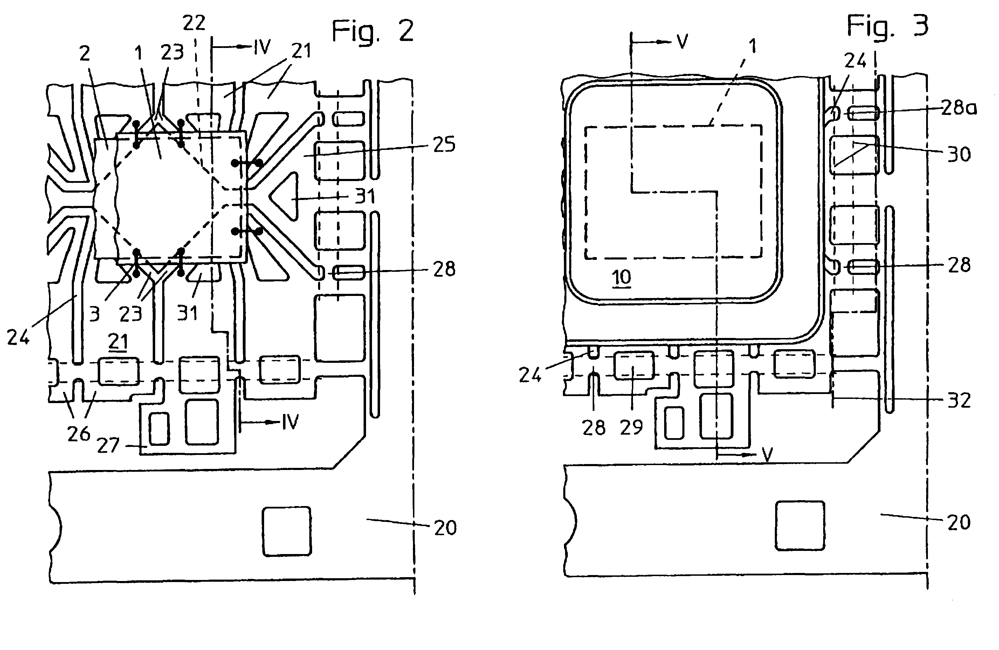

Anhand der Fig. 2, 3 und 4 werden nun wesentliche Herstellungsschritte des Elektronikmoduls, ausgehend vom Systemträger 20 nach Fig. 1, beschrieben. Gemäss Fig. 2 ist ein rechteckiger Halbleiter-Chip 1 auf der Insel 22 des Systemträgers montiert.

Dieser Chip ist etwas kleiner als das maximal mögliche Format 1b nach Fig. 1, jedoch ragt der Chip 1 erheblich über die Chip-Insel hinaus und überdeckt benachbarte Teile der Aussenkontakte 21. Es sind bereits Drahtverbindungen 3 von der Halbleiterschaltung auf dem Chip zu den einzelnen Aussenkontakten 21 auf bekannte Weise hergestellt worden. Für die Montage des Chips bzw. dessen mechanische Verbindung mit der Blechstruktur des Systemträgers 20 wird mit Vorteil eine isolierende Klebefolie 2 verwendet. Diese hat hier etwa das Format des Chips und besteht aus einem temperaturbeständigen Kunststoff (z.B. Polyimid oder Polyester) mit einer Klebstoff-Beschichtung, welche bei erhöhter Temperatur polymerisiert. Eine solche Montagefolie 2 hat den Vorteil, erhebliche Unterschiede in der Wärmedehnung zwischen dem metallenen Systemträger und dem Material des Chips auszugleichen und ausserdem Schläge, die von aussen auf den Systemträger einwirken, gegenüber dem Chip zu dämpfen. Ferner wird durch die Folie 2 der Chip 1 gegenüber den Aussenkontakten 21 elektrisch isoliert. Montage und Kontaktierung (Herstellen der Drahtverbindungen 3) des Chips 1 gemäss Fig. 2 erfolgen vollautomatisch auf leistungsfähigen Montageeinrichtungen, wie sie für die Halbleitermontage auf Systemträgem bewährt und verbreitet sind.

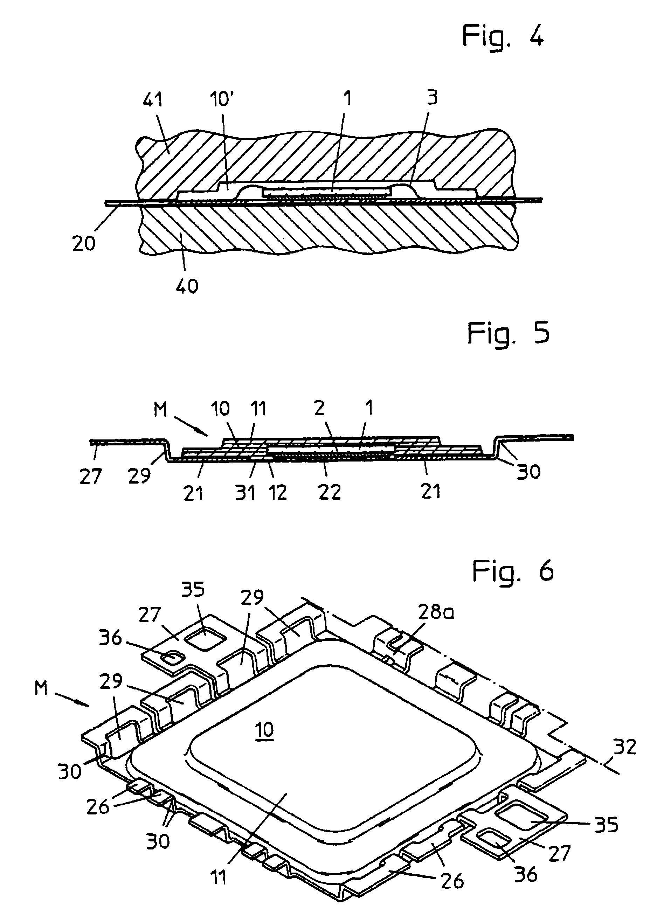

Anschliessend an die Montage nach Fig. 2 wird der bestückte Systemträger 20 zwecks Herstellung eines flachen Kunststoffgehäuses In eine Spritzgiessform eingebracht, wie schematisch in Fig. 4 dargestellt ist; vorzugsweise handelt es sich um eine Mehrfachform, welche mehrere Moduleinheiten gleichzeitig aufnimmt. Auf der im wesentlichen ebenen, unteren Formhälfte 40 liegt der ebenfalls ebene Systemträger 20 ganzflächig auf, während die obere Formhälfte 41 den Formhohlraum 10' bildet. In diesem werden der Chip 1 und Teile des Systemträgers 20 beim Spritzglessen mit Kunststoffmasse umpresst und die Aussenkontur des Gehäuses 10 geformt.

Das ausgeformte Zwischenprodukt mit dem Gehäuse 10 ist in Fig. 3 dargestellt. Beim Spritzgiessen sind sämtliche Schlitze 23 und 24 bis zu den Stegen 28 und ausserdem sämtliche Druchbrechungen 31 (Fig. 1) mit der Kunststoffmasse gefüllt worden. Diese schliesst mit der Aussenseite des Systemträgers 20 (auf der unteren Formhälfte 40 aufliegend, Fig. 4) überall bündig ab; dies gilt insbesondere auch im Querschnitt sämtlicher Durchbrechungen 31. Der Kunststoff des Gehäuses 10 bildet also zusammen mit der Aussenseite der Kontakte 21 des Systemträgers die eine, ebene Flachseite 12 des Elektronikmoduls (siehe Fig. 5).

Als Kunststoffmasse für das Gehäuse 10 wird ein Duroplast oder Kunstharz mit möglichst geringem Wärmeausdehnungskoeffizienten verwendet, wie sie zum Umpressen von Silicium-Chips bekannt sind (sogenannte "low stress"-Masse mit hohem Quarzanteil). Das Metall des Systemträgers 20 hat demgegenüber einen hohen Ausdehnungskoeffizienten und dehnt sich in der Pressform bei der Temperatur des eingepressten Kunststoffes entsprechend aus. Beim nachherigen Abkühlen des Metalls schrumpft dieses entsprechend und umschliesst bei den Durchbrechungen 31 den diese ausfüllenden, aushärtenden Kunststoff, wobei ein Pressitz hoher Festigkeit und Dichte entsteht. Dadurch wird eine mechanisch stabile Verankerung zwischen den Metallteilen und dem Gehäuse-Kunststoff erreicht, ohne dass der letztere sich beim Giessvorgang ausserhalb der Blechteile ausbreiten muss und ohne dass eine Verformung oder Dickenbearbeitung des Metalls erforderlich wäre.

Das flache Kunststoffgehäuse 10 kann in der Dicke abgestuft sein, beispielsweise wie es aus den Figuren 4 bis 6 hervorgeht. Die volle Gehäusedicke ist dabei nur in einem zentralen Bereich vorhanden, wo die Kunststoffmasse den Chip umschliesst und die den Aussenkontakten bzw. der Flachseite 12 gegenüberliegende Gehäuse-Flachseite 11 bildet.

Das nach dem Pressen des Kunststoffgehäuses 10 ausgeformte Zwischenprodukt nach Fig. 3 wird in folgender Weise weiterverarbeitet: Zunächst wird entlang von zwei symmetrischen Linien 32 (wovon nur eine in Fig. 3 sichtbar ist) das Modul aus dem Rahmen des Systemträgers 20 freigeschnitten. Gleichzeitig werden rings um das Gehäuse die Stege 28 ausgestanzt, mit Ausnahme eines Steges 28a (Fig. 3 und 6), welcher die Chip-Insel 22 über die eine Brücke 25 mit dem einen Aussenkontakt (oben rechts in Fig. 1) elektrisch verbindet, welcher den Masseanschluss für die Schaltung des Moduls bildet. In diesem Zustand kann das Elektronikmodul nun über seine Aussenkontakte elektrisch getestet werden. Sodann werden im vorliegenden Fall, wo das Modul zum Eingiessen in einen flachen Kunststoff-Trägerkörper bestimmt ist (z.B. Chipkarte im Kreditkartenformat), die Blech-Fortsätze 26 und 27 rings um das Gehäuse 10 entlang den Biegelinien 30 abgeknöpft, wie aus den Fig. 5 und 6 hervorgeht. Diese Abkröpfungen erfolgen in Richtung zu der dem Systemträger 20 gegenüberliegenden Modulseite 11 hin; im vorliegenden Beispiel erstrecken sie sich über die ganze Dicke des Moduls M so, dass die Enden der genannten Fortsätze in die Ebene der den Aussenkontakten 21 gegenüberliegenden Gehäuse-Flachseite 11 zu liegen kommen. Die beiden Fortsätze 27, welche bezüglich des Gehäuses 10 einander gegenüberliegen, sowie ein Teil der Fortsätze 26 sind jeweils mit den Aussenkontakten 21 mechanisch verbunden, während weitere Fortsätze 26 von den beiden mit der Chip-Insel 22 verbundenen Brücken 25 ausgehen (Fig. 1). Die weiter oben im Zusammenhang mit Fig. 1 erwähnten Durchbrechungen oder "Fenster" 29 befinden sich nun im Bereich der Abkröpfungen (Fig. 5 und 6).

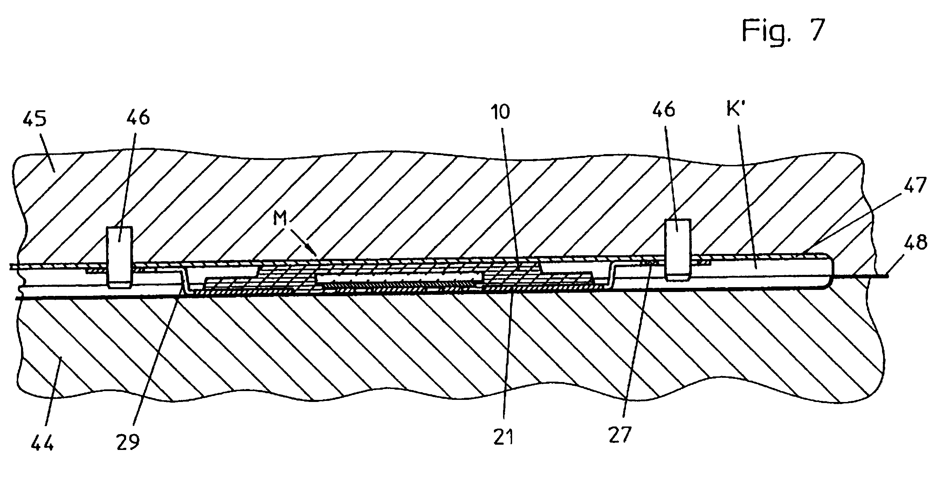

Das fertiggestellte Elektronikmodul M nach Fig. 5 und 6 ist nun bereit, um in eine Spritzgiessform nach Fig. 7 mit den Formhälften 44 und 45 eingelegt zu werden. In den Enden der beiden Fortsätze 27 sind zweckmässigerweise Oeffnungen 35 vorgesehen für den Angriff von Greifem eines Montageroboters. Daneben befinden sich Zentrieröffnungen 36, in die Zentrierstifte 46 der Giessform nach Fig. 7 eingreifen, um das Modul M im Formhohlraum K' für die Chipkarte genau zu positionieren. Es ist hervorzuheben, dass diese Positionierung direkt an den Aussenkontakten des Moduls erfolgt und nicht mittelbar über das Modulgehäuse.

Die ausserhalb des Kunststoffgehäuses 10 liegenden Fortsätze 27 des Systemträgers 20 sind allgemein zum Zusammenwirken mit Montageautomaten beim Handling der Module M bestimmt. Deren (z.B. wie dargestellt ausgebildete) Greifer- und/oder Positionierungskonturen 35, 36 an der Metailstruktur stehen zu den Aussenkontakten 21 des Moduls in genauer Lagebeziehung. Damit wird ein sicheres automatisches Manipulieren und genaues Positionieren beispielsweise auch bei Testoperationen, beim Verpacken usw. gewährleistet. Eine hohe Positioniergenaulgkeit ist dabei einerseits durch die Metallstruktur (anstelle des Kunststoffs), aber auch durch den relativ grossen Abstand zwischen den Konturen 35, 36 an den beiden Fortsätzen 27 gegeben.

In die Giessform 44, 45 nach Fig. 7 kann eine dünne Dekorationsfolie 48 eingelegt werden, auf die das Elektronikmodul M mit seiner Flachseite 12 bzw. mit den Aussenkontakten zu liegen kommt. Es handelt sich um eine bedruckte Folie für ein Thermotransfer-Druckverfahren, bei dem das Druckmuster auf der Folie sich nur mit dem in den Formhohlraum K' einzuspritzenden Kunststoff verbindet, nicht aber mit den Metallteilen des Elektronikmoduls. Mit der Folie 48 wird auf an sich bekannte Weise die betreffende Seite der Chipkarte bedruckt. Das Elektronikmodul M ist in der oberen Formhälfte 45 von einer Etikette 47 überdeckt, die sich über das ganze Chipkarten-Format erstreckt und ihrerseits bedruckt ist. Das Einspritzen des die Chipkarte bildenden Kunststoffes (Thermoplast, vorzugsweise ABS) In den Formhohlraum K' erfolgt ebenfalls nach bekannter Technik. Dabei wird das Modul M, mit dem Material der Karte genau fluchtend, an seinen Rändern rings umgossen. Das Thermoplastmaterial tritt dabei durch die "Fenster" 29 wie auch seitlich zwischen sämtlichen Fortsätzen 26, 27 hindurch. Es entsteht dabei eine äusserst stabile mechanische Verankerung der Metallteile des Moduls, insbesondere seiner Aussenkontakte, mit dem Material der Karte. Von Bedeutung ist auch, dass das Modul weder an der einen noch an der anderen Flachseite mit Thermoplast hintergossen wird, d.h. die Dicke des Elektronikmoduls ist gleich der Dicke des Thermoplastmaterials der Karte. Es steht also für das Modulgehäuse 10 die gesamte mögliche Dicke zur Verfügung: Bei der genormten Kartendicke von maximal 0,84 mm und einer Dicke der Etikette 47 von z.B. 0,12 mm ergibt sich somit eine Dicke des Modulgehäuses 10 von 0,72 mm.

Das beschriebene Elektronikmodul bzw. geeignete Varianten desselben empfiehlt sich auch zum Eingiessen in andern flache Kunststoff-Gegenstände bzw. Trägerkörper wie z.B. elektronische Schlüssel. Grundsätzlich sind jedoch auch andere Einbau- und Verwendungsarten möglich, wo die Flachbauweise des Moduls verlangt ist oder besondere Vorteile bringt, wie etwa bei Komponenten für Oberflächenmontage (SMD-Technik, surface mounted devices).

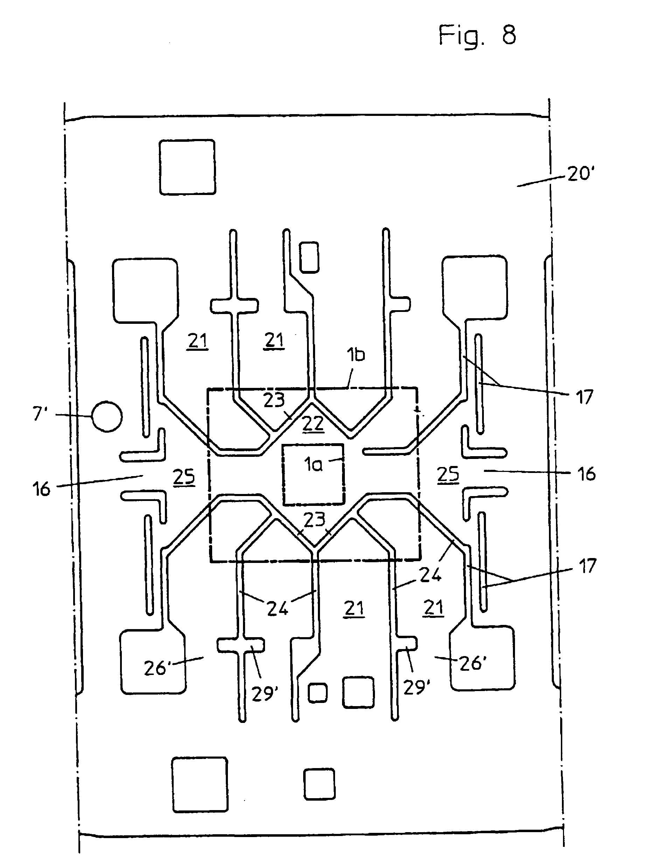

Eine weitem Ausführungsform eines Elektronikmoduls in Flachbauweise bzw. deren Herstellung geht aus den Fig. 8 bis 13 hervor das Spritzgiessen des Modulgehäuses und das Eingiessen des Moduls in eine Karte (oder einen anderen Tragkörper) sind indessen nicht separat dargestellt und es wird auf die betreffenden Fig. 4 und 7 mit zugehöriger Beschreibung verwiesen. Manche Teile des Moduls gemäss der Variante nach Fig. 8 - 13 entsprechen denjenigen des vorstehend beschriebenen Beispiels und sind mit gleichen Bezugszahlen bezeichnet.

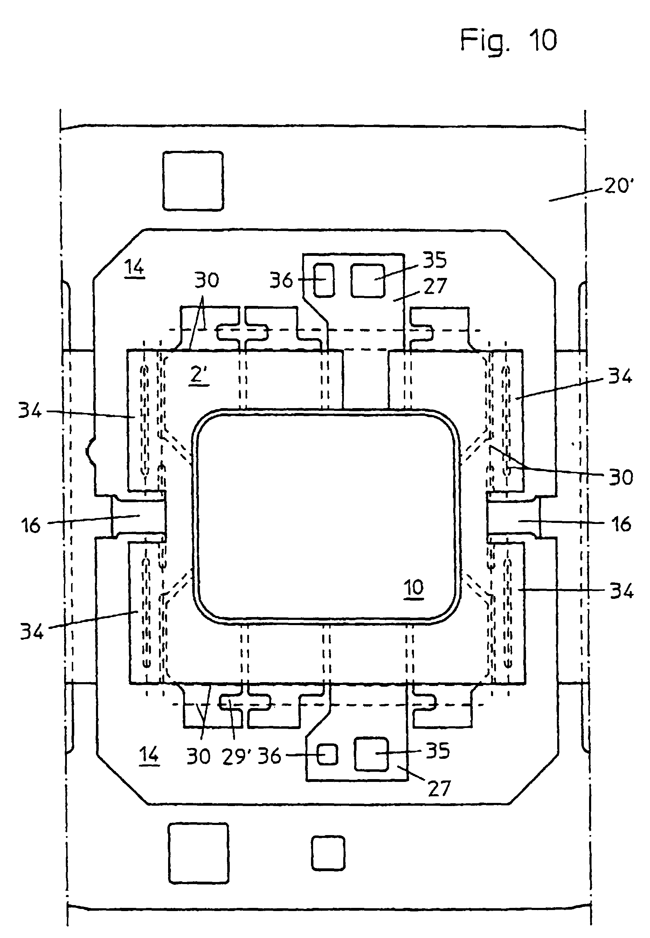

Am Systemträger 20' nach Fig. 8 sind dagegen folgende Abweichungen zu erwähnen: an den Aussenkontakten 21 sind die von der Chip-Insel 22 entfernten Partien nicht untereinander über Stege verbunden (wie 28 nach Fig. 1), sondern sie gehen getrennt in die Seitenränder des Systemträgers 20' über. Die Kontakte 21 weisen keine Durchbrechungen (wie 31 und 29) auf. Es sind dagegen seitliche Einschnitte 29' vorgesehen, auf welche Biegelinien 30 zu liegen kommen, wie aus Fig. 10 hervorgeht. An den die Chip-Insel haltenden Brücken 25 sind die aussenliegenden Partien über Stege 16 mit dem Systemträger verbunden, und zu beiden Seiten der Stege 16 sind Schlitze 17 vorgesehen, die zueinander und zu den Kontakten 21 parallel laufen und auf die weitere Biegelinien 30 (Fig. 10) zu liegen kommen.

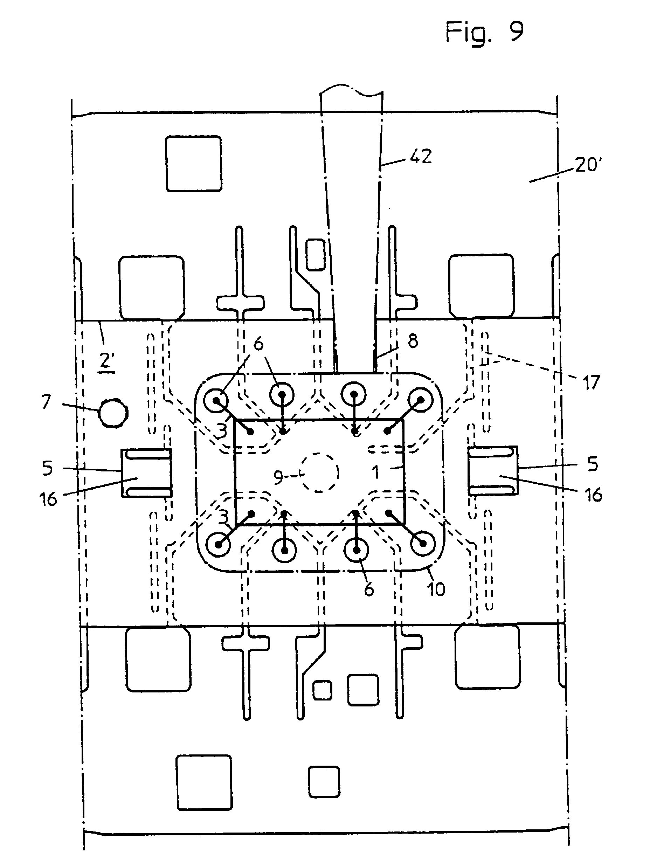

In Fig. 9 ist der auf dem Systemträger 20' montierte und über Leitungen 3 mit den Aussenkontakten 21 elektrisch verbundene Chip 1 dargestellt. Der Chip 1 ist mit dem Systemträger 20' wiederum mittels einer dazwischenliegenden, isolierenden Montagefolie 2' verbunden, jedoch ist bei der vorliegenden Ausführung die Folie 2' weit über das Format des Chips 1 ausgedehnt, indem sie sich auch über die Kontakte 21 und die Brücken 25 sowie die Schlitze 17 erstreckt; insbesondere überdeckt die Folie auch alle Schlitze 23 und 24, die die Chip-Insel und die Aussenkontakte begrenzen. Die Folie 2' ist z. B. aus Bandmaterial hergestellt (typischerweise Polyimid, z.B. "KAPTON" oder "MYLAR" von ca. 50 pm Dicke) und weist folgende Ausstanzungen auf, die vor dem Aufbringen auf dem Systemträger 20' gestanzt wurden:
- zwei Oeffnungen 5, welche die Stege 16 frei lassen,
- Oeffnungen 6 für die Durchführung der Drähte 3 auf die Aussenkontakte 21,
- eine Zentrierbohrung 7, die mit einer entsprechenden Bohrung 71 (Fig. 8) zur Deckung gebracht wird,
- einen Randausschnitt 8 im Bereich eines Angusses 42, der beim Spritzgiessen des Modul-Gehäuses 10 entsteht (Teile 42 und 10 in Fig. 9 strichpunktiert),
- bei Bedarf kann im Bereich der Chip-Insel eine Oeffnung 9 angebracht sein, um die Unterseite des Chips mittels einem leitenden Kleber mit dem Systemträger zu verbinden.

Der vorbereitete Folienabschnitt 2' Kann auf den Systemträger 20' auflaminiert werden, wie weiter oben bei der Klebefolie 2 im Zusammenhang mit Fig. 2 beschrieben. Die Montage des Chips 1 auf der Klebefolie und die Kontaktierung (Drahtverbindungen 3) erfolgen anschliessend ebenfalls wie beschrieben.

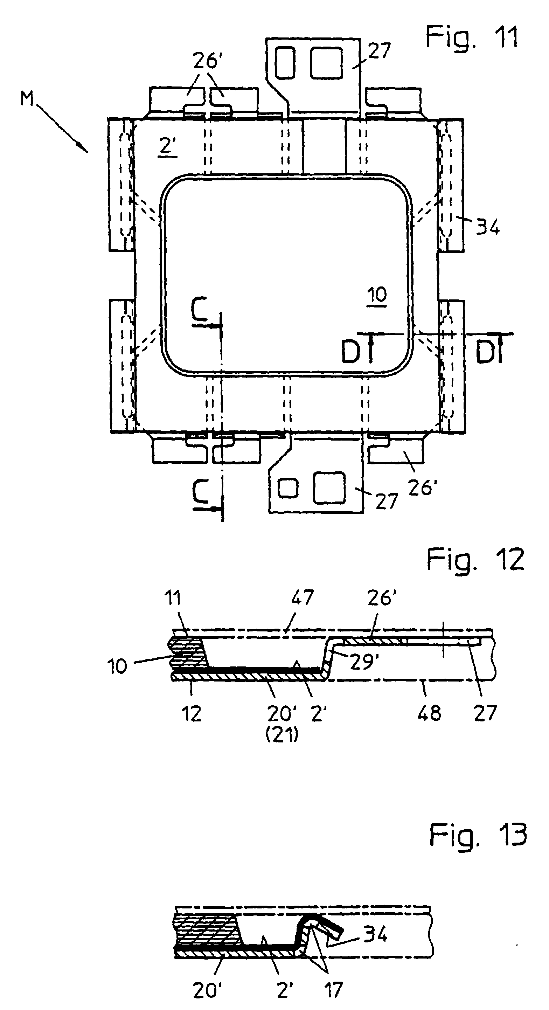

Die Folie 2' erfüllt hier, ausser der "elastischen", mechanischen Verbindung zwischen Chip und Systemträger, weitere Aufgaben: Durch die Klebefolie wird eine grossflächige, innige Verbindung zwischen den nebeneinanderliegenden Kontakten 21, der Chip-Insel 22 und den Brücken 25 hergestellt. Beim Spritzgiessen des Gehäuses 10 (in einer Form analog Fig. 4) verhindert die Folie 2' das Eindringen von Kunststoffmasse in die Schlitze 23, 24 und unter die Aussenkontakte 21 auf der Modul-Aussenseite, d.h. das Entstehen von störendem "Flash" an der Aussenseite wird verhindert. Das an sich isolierende (hochohmige) Folienmaterial und/oder die Klebstoffschicht kann euch eine gewisse gezielte (geringe) elektrische Leitfähigkeit aufweisen, wodurch Spannungsspitzen, z.B. infolge elektrostatischer Entladungen, die auf die Aussenkontakte gelangen, wirksam gedämpft werden (sogenannter "ESD-Schutz"); bei Chip-Karten ist dies besonders wichtig, weil dort die Anschlüsse der integrierten Schaltung des Chips, d.h. die Aussenkontakte, freiliegen und voneinander isoliert sind. Eine weitere, wichtige Funktion der Folie 2' im Bereich der Schlitze 17 wird weiter unten anhand der Fig. 11 und 13 erläutert.

Beim vorlegenden, zweiten Ausführungsbeispiel erfolgt die mechanische Verbindung des Gehäuses 10 mit dem Systemträger 20' praktisch ausschliesslich mittelbar über die Folie 2'. Es hat sich erwiesen, dass die Haftung des Gehäuse-Kunststoffes auf der Folie 2' einerseits und die Haftung der Folie auf dem Systemträger anderseits erheblich stärker ist als die direkte Haftung zwischen den Materialien von Gehäuse und Systemträger. Die Klebefolie 2' macht also das Modul M erheblich robuster, vor allem verhindert sie wirksam ein Ablösen oder Ausreissen der Aussenkontakte aus der Oberfläche der Chipkarte. - Umgekehrt lässt sich nach dem Spritzgiessen des Gehäuses 10 der Anguss 42, der sich direkt auf dem Blech des Systemträgers befindet, von letzterem leicht ablösen und am Gehäuserand abbrechen.

Nachdem das Modul aus der Spritzgiessform für das Gehäuse 10 entnommen und der Anguss entfernt worden ist, werden gemäss Fig. 10 zwei symmetrische Flächen 14 aus dem Systemträger 20' ausgestanzt, wobei das Modul jedoch noch an den beiden Stegen 16 gehaften bleibt. Bei diesem Freistanzen werden die Kontakte 21 aussen abgetrennt, wobei sie jedoch durch die Klebefolie 2' mit dem Gehäuse 10 verbunden sind. Mit demselben Stanzvorgang werden die Konturen der Fortsätze 27 gebildet (gleichzeitig kann im oberen Fortsatz 27, wo sich der Anguss 42 befand, die Oeffnung 35 gestanzt werden). Zu beiden Seiten der beiden Stege 16, im Bereich der Schlitze 17, sind nun auch vier Lappen 34 freigastanzt worden.

Als nächster Schritt werden nun die am Rand des Moduls liegenden Blechpartlen des Systemträgers entlang den Blegelinien 30 in einem Blegewerkzeug gekröpft; die Stege 16 bleiben dabei jedoch flach und halten das Modul noch im Verband des Systemträgers. Schliesslich werden in einem weiteren Stanzwerkzeug auch die Stege 16 weggeschnitten und damit die fertigen Module M aus dem Systemträger 20' gelöst (Fig. 11).

Die in der beschriebenen Weise vollautomatisch produzierten Module M nach Fig. 11 - 13 können nun, analog wie beim vorangehenden Beispiel anhand Fig. 7 beschrieben, in eine Chipkarte oder einen anderen Träger im Spritzgiessverfahren eingegossen werden. Dabei ergeben sich im wesentlichen dieselben Eigenschaften und Vorteile hinsichtlich zuverlässiger Verankerung usw. Das Umgiessen und Verbinden mit dem umgebenden Kunststoff des Trägerkörpers erfolgt wiederum an der das Modulgehäuse 10 umgebenden ebenen Fläche (von der Folie 2' bedeckt) und an den abgekröpften Teilen 26', 27 und 34, wie aus den Fig. 11 - 13 leicht zu erkennen ist.

Aus der Fig. 13 ist schliesslich die weiter oben angedeutete weitere Funktion der über die Schlitze 17 gezogenen Folie 2' ersichtlich: Beim Spritzgiessen des Trägerkörpers (Chipkarte) dringt der Kunststoff in die Schlitze 17 ein, bleibt dort aber durch die Folie 2' getrennt. Dies ergibt eine vorteilhafte "Scharnierwirkung" entlang den Schlitzen 17, d.h. Biegungen der Karte werden dort weitgehend aufgenommen und entsprechend vom Modul M bzw vom Chip 1 ferngehalten. Bei Bedarf wäre es selbstverständlich möglich, auch im Bereich der Fortsätze 26' und 27 an den Aussenkontakten dieselbe Massnahme vorzusehen, d.h. auch dort Schlitze vorzusehen und die Folie 2' bis über die Fortsätze bzw. den Bereich der Abkröpfungen auszudehnen. Bei Chipkarten ist es allerdings so, dass - infolge der bekannten, genormten Anordnung des Moduls M innerhalb des rechteckigen Kartenfomats - die Verbindung der Lappen 34 mit dem Kartenmaterial erheblich grösseren Biegebeanspruchungen ausgesetzt ist als die entsprechende Verbindung bei den Fortsätzen 26', 27.

## Patentansprüche

1. Elektronikmodul in Flachbauweise, mit Aussenkontakten (21), die in einer Ebene an der einen Flachseite (12) eines Kunststoffgehäuses (10) liegen und aus einem Systemträger (20, 20') in Form einer flachen Blechstruktur gebildet sind, und einem Halbleiter-Chip (1), der auf der einen Flachseite des Systemträgers (20, 20') über einer Chip-Insel (22) montiert, von der Kunststoffmasse des Gehäuses (10) umpresst und mit den Aussenkontakten (21) verbunden ist, dadurch gekennzeichnet, dass der Halbleiter-Chip (1) mittels einer isolierenden Klebefolie (2, 2') auf der Chip-Insel (22) montiert ist.

2. Elektronikmodul nach Anspruch 1, dadurch gekennzeichnet, dass der Halbleiter-Chip (1) seitlich über die Chip-Insel (22) hinausragt und über die isolierende Klebefolie (2, 2') auch an benachbarten Bereichen von Aussenkontakten (21) haftet.

3. Elektronikmodul nach Anspruch 1, dadurch gekennzeichnet, dass die Klebefolie (2') sich durchgehend auch über die Aussenkontakte (21) erstreckt und mit diesen im wesentlichen ganzflächig verbunden ist.

4. Elektronikmodul nach einem der Ansprüche 1 bis 3, dadurch gekennzeichnet, dass die Klebefolie (2, 2') und/oder deren Klebstoffschicht eine geringe elektrische Leitfähigkeit aufweist.
